# EUROPÄISCHE PATENTSCHRIFT

(11) **EP 1 271 170 B1**
(45) Veröffentlichungstag und Bekanntmachung des Hinweises auf die Patenterteilung: **23.12.2009**
(21) Anmeldenummer: 02012595.1
(22) Anmeldetag: 06.06.2002
(51) Int. Cl.: G01R 31/36

(54) **Verfahren und Vorrichtung zur Batteriezustandserkennung**
Device and method for determining the condition of batteries
Appareil et procédé de détermination de l'état d'une batterie

(30) Priorität: 30.06.2001 DE 10131765
(43) Veröffentlichungstag der Anmeldung: 02.01.2003
(73) Patentinhaber: ROBERT BOSCH GMBH, 70442 Stuttgart (DE)
(72) Erfinder: Mentgen, Dirk, 71701 Schwieberdingen (DE); Schmucker, Clemens, 71732 Tamm (DE)

(56) Entgegenhaltungen:
- EP-A- 0 545 042
- DE-A- 19 750 309
- DE-A- 19 959 019
- US-A- 5 191 291

## Beschreibung

Die Erfindung betrifft ein Verfahren und eine Vorrichtung zur Batteriezustandserkennung.

### Stand der Technik

Kraftfahrzeugtaugliche Systeme zur Batteriezustandserkennung sind derzeit in der Entwicklung.

In der DE 199 59 019 ist ein Verfahren beschrieben, bei welchem Istgrößen wie die Batteriespannung, der Strom und die Temperatur als Eingangsgrößen voneinander entkoppelt jeweils einem modellbasierten Parameterschätzer und einem modellbasierten Modellbaustein, welcher in Form eines Kalman-Filters realisiert ist, zugeführt werden. Dieses Filter ist dazu in der Lage, die Zustandsgrößen mittels einer Strom- und Spannungsmessung so zu schätzen, dass diese den tatsächlichen Werten an der Batterie entsprechen. Dies erlaubt eine recht genaue Aussage über den Ladezustand der Batterie. Bei dieser bekannten Vorgehensweise werden Alterungserscheinungen der Batterie und sich durch Defekte einstellende Änderungen der Modellparameter, die dem Schätzungsmodell zugrunde liegen, vom Filter berücksichtigt. Dieses Filter liefert - nachdem eine Plausibilitätsprüfung erfolgt ist - Parameterdaten und einen Zustandsvektor an einen Prädiktor, mittels welchem verschiedene Belastungsfälle der Batterie simuliert und dadurch Rückschlüsse auf den Batteriezustand gezogen werden können.

Weiterhin ist aus der DE 197 50 309 A ein Verfahren zur Bestimmung der Startfähigkeit der Starterbatterie eines Kraftfahrzeugs bekannt. Bei diesem bekannten Verfahren wird der Mittelwert des Spannungseinbruchs beim Starten des Verbrennungsmotors gemessen und mit den Spannungswerten eines Kennlinienfeldes verglichen, welches aus gemessenen Spannungseinbrüchen und zugehörigen Batterie- sowie Motortemperaturen ermittelt wurde.

Aus der EP-A 545 042 ist eine Batterie mit dualen Ausgängen und Fehlerermittlung vorgesehen. Weiterhin sind zwei redundante Begrenzerschaltkreise vorgesehen, die in parallelen Pfaden der Begrenzung des Spannungs- und Stromniveaus dienen. Diese Begrenzungsschaltkreise sind jeweils mit erstem und zweitem Ausgang verbunden. Weiterhin ist eine Fehlerüberwachung vorgesehen, welche sämtliche Fehlerzustände erfasst, die an irgendeinem der beiden Ausgänge erfolgen können.

### Vorteile der Erfindung

Die Vorteile eines Verfahrens und einer Vorrichtung gemäß der Erfindung bestehen insbesondere darin, dass bei fehlerfreiem Betrieb die Batteriezustandserkennung mit hoher Genauigkeit arbeitet. Treten jedoch bei der Batteriezustandserkennung Fehler auf, dann muss nicht - wie bei herkömmlichen Systemen - auf eine Aussage über den Batteriezustand verzichtet werden, sondern es kann auf eine Rückfallebene zugegriffen werden. Dabei liefert ein zusätzlich vorhandenes weiteres Batteriezustandserkennungssystem Informationen über den Batteriezustand. Durch diese Rückfallebene wird die Verfügbarkeit eines Kraftfahrzeug-Bordnetzes im Vergleich zum Stand der Technik erhöht.

Vorzugsweise kommen hinsichtlich der Sensorik zwei unterschiedliche Verfahren zum Einsatz. Bei fehlerfreiem Betrieb wird eine Aussage über den Batteriezustand unter Verwendung einer Strom- und Spannungs- und ggf. auch Temperaturmessung gewonnen. Ist beispielsweise bei diesem System die Stromsensorik fehlerhaft, dann wird auf ein als Rückfallebene dienendes weiteres Batteriezustandserkennungssystem zurückgegriffen, welche von vorne herein auf eine Strommessung verzichtet und Aussagen zum Batteriezustand lediglich aus einer Batteriespannungsmessung gewinnt, die ggf. durch eine Temperaturmessung ergänzt werden kann.

In vorteilhafter Weise kann die vorstehend genannte Rückfallebene zusätzlich als Überwachungsebene verwendet werden, die bei fehlerfreiem Betrieb eine Plausibilitätsprüfung der vom ersten Batteriezustandserkennungssystem gelieferten Ergebnisse erlaubt.

### Zeichnung

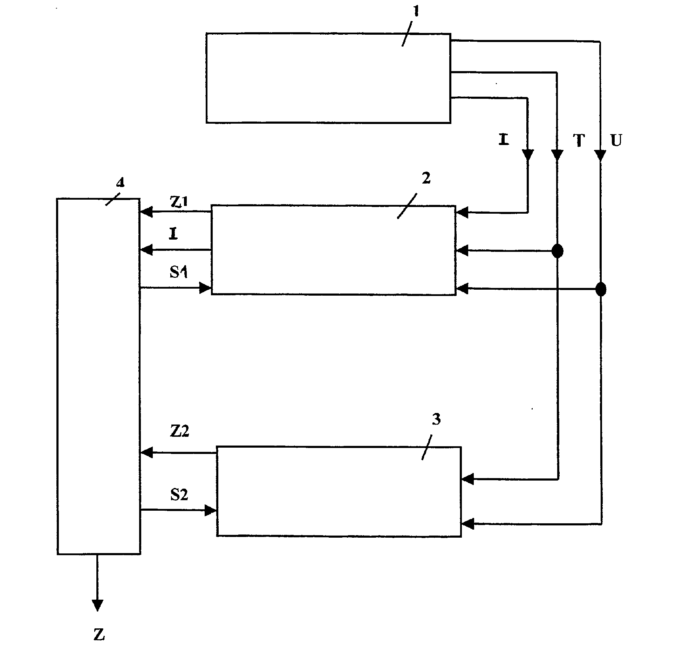

Nachfolgend wird anhand der Zeichnung ein Ausführungsbeispiel für die Erfindung näher erläutert.

### Beschreibung

In der Figur ist ein Blockdiagramm dargestellt, welches die zum Verständnis der Erfindung wesentlichen Bestandteile einer Vorrichtung zur Batteriezustandserkennung enthält.

Von einer in einem Kraftfahrzeug vorgesehenen Batterie 1 werden als Messparameter ein Spannungsmesswert U, ein Strommesswert I und ein Temperaturmesswert T abgeleitet. Diese Messparameter werden einem ersten Batteriezustandserkennungssystem 2 zugeführt. In diesem ersten Batteriezustandserkennungssystem 2 werden aus den genannten Messparametern Aussagen über den Batteriezustand ermittelt, die in Form von Batteriezustandssignalen Z1 an eine Steuereinheit 4 übermittelt werden. Bei dem genannten ersten Batteriezustandserkennungssystem 2 kann es sich um ein bekanntes System handeln, welches eine Batteriezustandserkennung auf Basis einer Stromintegration durchführt. Alternativ dazu kann das erste Batteriezustandserkennungssystem 2 nach einem modellbasierten Verfahren arbeiten, beispielsweise unter Verwendung eines Kalmanfilters, wie es in der DE 197 59 019 beschrieben ist. Diese Systeme, die auf einer Strommessung basieren, zeichnen sich dadurch aus, dass sie genaue Aussagen über den Batteriezustand liefern, anhand derer der Benutzer bei Bedarf rechtzeitig für einen Austausch der Batterie sorgen kann. Dadurch ist sichergestellt, dass das elektrische Bordnetz des Kraftfahrzeugs stets zur Verfügung steht, d. h. weder beim Anlassen des Fahrzeugs noch während dessen Betriebes Ausfälle auftreten.

Um sicherzustellen, dass auch bei fehlerhafter Arbeitsweise oder einem völligen Ausfall des ersten Batteriezustandserkennungssystems 2, insbesondere nach einem Ausfall der Stromsensorik, weiterhin Aussagen über den Batteriezustand getroffen werden können, ist ein zweites Batteriezustandserkennungssystem 3 vorgesehen. Diesem werden als Messparameter der Spannungsmesswert U und der Temperaturmesswert T zugeführt. Im zweiten Batteriezustandserkennungssystem 3 werden aus diesen Messparametern Aussagen über den Batteriezustand ermittelt, die in Form von Batteriezustandssignalen Z2 an die Steuereinheit 4 übermittelt werden. Auf eine Auswertung eines Strommesswertes wird im zweiten Batteriezustandserkennungssystem 3 von vorne herein verzichtet. Bei diesem zweiten Batteriezustandserkennungssystem kann es sich beispielsweise um ein System handeln, wie es aus der DE 197 50 309 A bekannt ist. Bei diesem System werden Spannungseinbrüche beim Starten des Motors gemessen und ausgewertet, wobei auch die Motortemperatur berücksichtigt wird.

Um einen Ausfall der Stromsensorik zu erkennen und rechtzeitig auf das als Rückfallebene dienende zweite Batteriezustandserkennungssystem 3 umschalten zu können, wird der von der Batterie 1 abgeleitete Strommesswert I auch der Steuereinheit 4 zugeführt. Erkennt diese einen Ausfall der Stromsensorik, dann verwirft sie die vom ersten Batteriezustandserkennungssystem 2 gelieferten Batteriezustandsdaten Z1 und leitet als Batteriezustandsdaten Z die ihr vom zweiten Batteriezustandserkennungssystem 3 gelieferten Batteriezustandsdaten Z weiter. Arbeitet das erste Batteriezustandserkennungssystem 2 hingegen fehlerfrei, dann stellt die Steuereinheit 4 an ihrem Ausgang zustandserkennungssystem 2 zur Verfügung gestellten Batteriezustandsdaten Z1 zur Verfügung.

Gemäß einer Ausgestaltung der Erfindung führt die Steuereinheit 4 dem ersten Batteriezustandserkennungssystem 2 Steuersignale S1 und dem zweiten Batteriezustandserkennungssystem 3 Steuersignale S2 zu deren Aktivierung bzw. Deaktivierung zu. Bei fehlerfreiem Arbeiten des ersten Batteriezustandserkennungssystems 2 ist das zweite Batteriezustandserkennungssystem 3 deaktiviert. Tritt im ersten Batteriezustandserkennungssystem 2 ein Fehler auf, dann wird das zweite Batteriezustandserkennungssystem 3 aktiviert und das erste Batteriezustandserkennungssystem 2 deaktiviert.

Gemäß einer anderen Ausgestaltung der Erfindung sind beide Batteriezustandserkennungssysteme 2 und 3 stets in Betrieb, wobei bei fehlerfrei arbeitendem ersten Batteriezustandserkennungssystem 2 die vom zweiten Batteriezustandserkennungssystem 3 gelieferten Batteriezustandsdaten Z2 zu einer Plausibilitätsprüfung der vom ersten Batteriezustandserkennungssystem 2 gelieferten Batteriezustandsdaten Z1 verwendet werden, welche Plausibilitätsprüfung in der Steuereinheit 4 erfolgt.

## Patentansprüche

1. Verfahren zur Batteriezustandserkennung, bei welchem Aussagen über den Batteriezustand mittels eines ersten Batteriezustandserkennungssystems gewonnen werden, **dadurch gekennzeichnet, dass** bei fehlerhaftem Betrieb oder bei einem Ausfall des ersten Batteriezustandserkennungssystems Aussagen über den Batteriezustand mittels eines zweiten Batteriezustandserkennungssystems gewonnen werden, wobei das erste Batteriezustandserkennungssystem Aussagen über den Batteriezustand unter Verwendung einer Strommessung und unter zusätzlicher Verwendung einer Temperaturmessung ermittelt.

2. Verfahren nach Anspruch 1, **dadurch gekennzeichnet, dass** das erste Batteriezustandserkennungssystem Aussagen über den Batteriezustand unter zusätzlicher Verwendung einer Spannungsmessung ermittelt.

3. Verfahren nach einem der vorhergehenden Ansprüche, **dadurch gekennzeichnet, dass** das zweite Batteriezustandserkennungssystem auf eine Strommessung verzichtet und Ausgaben über den Batteriezustand unter Verwendung einer Spannungsmessung ermittelt.

4. Verfahren nach Anspruch 3, **dadurch gekennzeichnet, dass** das zweite Batteriezustandserkennungssystem Aussagen über den Batteriezustand unter zusätzlicher Verwendung einer Temperaturmessung ermittelt.

5. Verfahren nach einem der vorherigen Ansprüche, **dadurch gekennzeichnet, dass** bei fehlerfreiem Betrieb des ersten Batteriezustandserkennungssystems unter Verwendung des zweiten Batteriezustandserkennungssystems die Plausibilität der mittels des ersten Batteriezustandserkennungssystems ermittelten Aussagen über den Batteriezustand überprüft werden.

6. Verfahren nach einem der Ansprüche 1 bis 4, **dadurch gekennzeichnet, dass** bei fehlerfreiem Betrieb des ersten Batteriezustandserkennungssystems das zweite Batteriezustandserkennungssystem deaktiviert wird.

7. Verfahren nach Anspruch 6, **dadurch gekennzeichnet, dass** beim Erkennen eines fehlerhaften Betriebes oder eines Ausfalls des ersten Batteriezustandserkennungssystems das zweite Batteriezustandserkennungssystem aktiviert und das erste Batteriezustandserkennungssystem deaktiviert wird.

8. Vorrichtung zur Batteriezustandserkennung, welche ein erstes Batteriezustandserkennungssystem (2) aufweist, **dadurch gekennzeichnet, dass** sie weiterhin ein zweites Batteriezustandserkennungssystem (3) aufweist, welches bei fehlerhaftem Betrieb oder einem Ausfall des ersten Batteriestandserkennungssystems (2) Aussagen über den Batteriezustand liefert, wobei das erste Batteriezustandserkennungssystem (2) einen Eingangsanschluss für einen Strommesswert (I) und für einen Temperaturmesswert (T) aufweist.

9. Vorrichtung nach Anspruch 8, **dadurch gekennzeichnet, dass** das erste Batteriezustandserkennungssystem (2) einen Eingangsanschluss für einen Spannungsmesswert (U) aufweist.

10. Vorrichtung nach einem der Ansprüche 8 oder 9, **dadurch gekennzeichnet, dass** das zweite Batteriezustandserkennungssystem (3) einen Eingangsanschluss für einen Spannungsmesswert (U) aufweist.

11. Vorrichtung nach Anspruch 10, **dadurch gekennzeichnet, dass** das zweite Batteriezustandserkennungssystem (3) einen Eingangsanschluss für einen Temperaturmesswert (T) aufweist.

12. Vorrichtung nach einem der Ansprüche 8 - 11, **dadurch gekennzeichnet, dass** sie eine Einheit (4) zur Plausibilitätsprüfung aufweist, welcher Batteriezustandssignale (Z1) vom ersten Batteriezustandserkennungssystem (2) und Batteriezustandssignale (Z2) vom zweiten Batteriezustandserkennungssystem (3) zugeführt werden, wobei die Einheit (4) zur Plausibilitätsprüfung die Plausibilität der vom ersten Batteriezustandserkennungssystem (2) gelieferten Batteriezustandsdaten (Z1) anhand der vom zweiten Batteriezustandserkennungssystem (3) gelieferten Batteriezustandsdaten (Z2) überprüft.

13. Vorrichtung nach einem der Ansprüche 7-12, **dadurch gekennzeichnet, dass** sie eine Steuereinheit (4) aufweist, die bei fehlerfreiem Betrieb des ersten Batteriezustandserkennungssystems (2) ein das zweite Batteriezustandserkennungssystem (3) deaktivierendes Steuersignal (S2) generiert und bei fehlerhaftem Betrieb oder einem Ausfall des ersten Batteriezustandserkennungssystems (2) ein das zweite Batteriezustandserkennungssystem (3) aktivierendes Steuersignal (S2) sow8ie ein das erste Batteriezustandserkennungssystem (2) deaktivierendes Steuersignal (S1) generiert.

14. Vorrichtung nach Anspruch 13, **dadurch gekennzeichnet, dass** die Steuereinheit (4) einen Eingangsanschluss für den Strommesswert (I) aufweist. -

## Claims

1. Method for battery state identification, in which statements relating to the battery state are obtained by means of a first battery state identification system, **characterized in that**, during faulty operation or in the event of a failure of the first battery state identification system, statements are obtained relating to the battery state by means of a second battery state identification system, wherein the first battery state identification system determines statements relating to the battery state by using a current measurement and by additionally using a temperature measurement.

2. Method according to Claim 1, **characterized in that** the first battery state identification system determines statements relating to the battery state by additionally using a voltage measurement.

3. Method according to one of the preceding claims, **characterized in that** the second battery state identification system dispenses with a current measurement and determines statements relating to the battery state by using a voltage measurement.

4. Method according to Claim 3, **characterized in that** the second battery state identification system determines statements relating to the battery state by additionally using a temperature measurement.

5. Method according to one of the preceding claims, **characterized in that**, during fault-free operation of the first battery state identification system, the plausibility of the statements relating to the battery state determined by means of the first battery state identification system is checked by using the second battery state identification system.

6. Method according to one of Claims 1 to 4,
**characterized in that**, during fault-free operation of the first battery state identification system, the second battery state identification system is deactivated.

7. Method according to Claim 6, **characterized in that**, on identification of faulty operation or of a failure of the first battery state identification system, the second battery state identification system is activated, and the first battery state identification system is deactivated.

8. Apparatus for battery state identification, which has a first battery state identification system (2), **characterized in that** the apparatus also has a second battery state identification system (3) which, during faulty operation or in the event of a failure of the first battery state identification system (2), provides statements relating to the battery state, wherein the first battery state identification system (2) has an input connection for a current measured value (I) and for a temperature measured value (T).

9. Apparatus according to Claim 8, **characterized in that** the first battery state identification system (2) has an input connection for a voltage measured value (U).

10. Apparatus according to one of Claims 8 or 9, **characterized in that** the second battery state identification system (3) has an input connection for a voltage measured value (U).

11. Apparatus according to Claim 10, **characterized in that** the second battery state identification system (3) has an input connection for a temperature measured value (T).

12. Apparatus according to one of Claims 8-11, **characterized in that** the apparatus has a unit (4) for plausibility checking, to which battery state signals (Z1) from the first battery state identification system (2) and battery state signals (Z2) from the second battery state identification system (3) are supplied, wherein the unit (4) for plausibility checking uses the battery state data (Z2) provided by the second battery state identification system (3) to check the plausibility of the battery state data (Z1) provided by the first battery state identification system (2).

13. Apparatus according to one of Claims 7-12, **characterized in that** the apparatus has a control unit (4) which, during fault-free operation of the first battery state identification system (2), generates a control signal (S2) which deactivates the second battery state identification system (3) and, during faulty operation or in the event of a failure of the first battery state identification system (2), generates a control signal (S2), which activates the second battery state identification system (3), as well as a control signal (S1), which deactivates the first battery state identification system (2).

14. Apparatus according to Claim 13, **characterized in that** the control unit (4) has an input connection for the current measured value (I).

## Revendications

1. Procédé de détection de l'état d'une batterie, qui permet de tirer des conclusions sur l'état de la batterie au moyen d'un premier système de détection d'état de la batterie,
**caractérisé en ce que**
lorsque le système de détection d'état de la batterie fonctionne incorrectement ou est en panne, des conclusions sur l'état de la batterie sont prises au moyen d'un deuxième système de détection d'état de la batterie, le premier système de détection d'état de la batterie déterminant des conclusions sur l'état de la batterie en recourant à une mesure de courant et en recourant en supplément à une mesure de température.

2. Procédé selon la revendication 1, **caractérisé en ce que** le premier système de détection d'état de la batterie détermine des conclusions sur l'état de la batterie en recourant en supplément à une mesure de tension.

3. Procédé selon l'une des revendications précédentes, **caractérisé en ce que** le deuxième système de détection d'état de la batterie n'effectue pas de mesure de courant et détermine des conclusions sur l'état de la batterie en recourant à une mesure de tension.

4. Procédé selon la revendication 3, **caractérisé en ce que** le deuxième système de détection d'état de la batterie détermine des conclusions sur l'état de la batterie en recourant en supplément à une mesure de température.

5. Procédé selon l'une des revendications précédentes, **caractérisé en ce que** lorsque le premier système de détection d'état de la batterie ne fonctionne pas correctement, un recours au deuxième système de détection d'état de la batterie permet de vérifier la plausibilité des conclusions déterminées à propos de l'état de la batterie au moyen du premier système de détection de l'état de la batterie.

6. Procédé selon l'une des revendications 1 à 4, **caractérisé en ce que** lorsque le premier système de détection d'état de la batterie fonctionne correctement, le deuxième système de détection d'état de la batterie est désactivé.

7. Procédé selon la revendication 6, **caractérisé en ce que** s'il est détecté que le premier système de détection d'état de la batterie ne fonctionne pas correctement ou est en panne, le deuxième système de détection d'état de la batterie est activé et le premier système de détection d'état de la batterie est désactivé.

8. Dispositif de détection d'état d'une batterie, qui présente un premier système (2) de détection d'état de la batterie, **caractérisé en ce qu'**il présente en outre un deuxième système (3) de détection d'état de la batterie qui, lorsque le premier système (2) de détection d'état de la batterie ne fonctionne pas correctement ou est en panne, délivre des conclusions sur l'état de la batterie, le premier système (2) de détection d'état de la batterie présentant une borne d'entrée pour une valeur (I) de mesure de courant et pour une valeur (T) de mesure de température.

9. Dispositif selon la revendication 8, **caractérisé en ce que** le premier système (2) de détection d'état de la batterie présente une borne d'entrée pour une valeur (U) de mesure de tension.

10. Dispositif selon l'une des revendications 8 ou 9, **caractérisé en ce que** le deuxième système (3) de détection d'état de la batterie présente une borne d'entrée pour une valeur (U) de mesure de tension.

11. Dispositif selon la revendication 10, **caractérisé en ce que** le deuxième système (3) de détection d'état de la batterie présente une borne d'entrée pour une valeur (T) de mesure de température.

12. Dispositif selon l'une des revendications 8 à 11, **caractérisé en ce qu'**il présente une unité (4) de vérification de plausibilité à laquelle des signaux (Z1) d'état de la batterie sont apportés par le premier système (2) de détection d'état de la batterie et des signaux (Z2) d'état de la batterie sont apportés par le deuxième système (3) de détection d'état de la batterie, l'unité (4) de vérification de plausibilité vérifiant la plausibilité des données d'état de la batterie (Z1) délivrées par le premier système (2) de détection d'état de la batterie à l'aide des données (Z2) d'état de la batterie délivrées par le deuxième système (3) de détection d'état de la batterie.

13. Dispositif selon l'une des revendications 7 à 12, **caractérisé en ce qu'**il présente une unité de commande (4) qui, lorsque le premier système (2) de détection d'état de la batterie fonctionne correctement, délivre un signal de commande (S2) qui désactive le deuxième système (3) de détection d'état de la batterie et qui, lorsque le premier système (2) de détection d'état de la batterie ne fonctionne pas correctement ou est en panne, délivre un signal de commande (S2) qui active le deuxième système (3) de détection d'état de la batterie ainsi qu'un signal de commande (S1) qui désactive le premier système (2) de détection d'état de la batterie.

14. Dispositif selon la revendication 13, **caractérisé en ce que** l'unité de commande (4) présente une borne de raccordement pour la valeur (I) de mesure du courant.
